# EUROPEAN PATENT APPLICATION

(11) **EP 2 924 718 A1**
(43) Date of publication of application: **30.09.2015**
(21) Application number: 13856341.6
(22) Date of filing: 21.11.2013
(51) Int. Cl.: H01L 21/441

(54) **METHOD FOR CREATING ELECTRICAL CONTACTS AND CONTACTS CREATED IN THIS WAY**

(30) Priority: 22.11.2012 ES 201201168
(71) Applicant: Abengoa Solar New Technologies, S.A., 41014 Sevilla (ES)
(72) Inventor: MOLPECERES ÁLVAREZ, Carlos Luis, E-41014 - Sevilla (ES); MORALES FURIO, Miguel, E-41014 - Sevilla (ES); SÁNCHEZ-ANIORTE, María Isabel, E-41014 - Sevilla (ES); COLINA BRITO, Mónica Alejandra, E-41014 - Sevilla (ES); MURILLO GUTIÉRREZ, Joaquín, E-41014 - Sevilla (ES); DELGADO SÁNCHEZ, José María, E-41014 - Sevilla (ES); SÁNCHEZ CORTEZÓN, Emilio, E-41014 - Sevilla (ES)
(74) Representative: Garcia-Cabrerizo y del Santo, Pedro Maria
(86) International application number: PCT/ES2013/000259
(87) International publication number: WO 2014/080052

(57) **Abstract**

The present invention relates to a method for creating electrical contacts in optoelectronic and electronic devices, including high and low concentration solar cells, thin films, organic light emitting diodes (OLED) and in general any device requiring the extraction or injection of a current by means of electrical contacts. The method comprises the following stages: (a) depositing the contact material on the final substrate through the laser induced forward transfer (LIFT) of said material from a donor substrate to the final substrate, preferably using a pulsed laser and (b) sintering the contact material using a laser source, preferably a continuous laser. The contacts thus created present excellent conductivity and adherence properties, as well as high height (thickness) to width ratios.

## Description

### Technical field of the invention

The present invention's field of application is the manufacture of optoelectronic devices, including high and low concentration solar cells, thin films, organic light emitting diodes (OLED) and in general any device requiring the extraction or injection of a current by means of electrical contacts. In particular, the invention refers to a method for creating electrical contacts in electronic and optoelectronic devices.

### Background to the invention

The deposition techniques for electrical contacts currently in use in the industry involve various steps in their application before the contact is fully operative. These techniques involve depositing the conductor on the final substrate, regrowth made necessary due to the technique used, and sintering the deposit in order to maximise its conductive characteristics and adherence to the substrate.

One of the most widespread techniques for creating metallic contacts, especially in commercial solar cells, is serigraphy, which involves transferring a layer of material with a desired pattern to the surface of the wafer (optoelectronic device). The basic elements of this technology are screens and pastes. However, this technique presents some disadvantages: it is an expensive technique, necessitating screen changes depending on the template to be used and control of the process parameters is not easy. Moreover, it does not allow for two different metallic pastes to be deposited without intermediate thermal treatment. Furthermore, obtaining high ratios between the height (thickness) and width of the metallic line deposited, known as the "aspect ratio", is desirable for an efficient contact, as minimum conductor resistance (maximum height or thickness) with a minimum contact area (the contact area on a cell is the lost area on which sunlight does not fall) is desired. The greater the line heights of a deposited layer with the same width, the better the results.

In addition, serigraphy requires the application of pressure on the device, which on occasions may lead to its being broken.

Although the technique of depositing the conducting material on a final substrate from a donor substrate containing the same by means of laser induced forward transfer (LIFT) is also known, it cannot be considered technically complete, as it requires either regrowth of the contact using electroplating techniques or sintering in a furnace in order to obtain useful resistivity and adherence. The problem with conventional sintering in a furnace is that it inevitably produces thermal effects on the whole device. This can change the characteristics not only of the metallic contacts but also of the rest of the device. The present invention avoids heating that could be harmful to other components of the part (whether type p or type n semiconductive layers, the semiconductor's p-n hetero-junction, transparent conductive layers or even the substrate itself).

The proposed invention resolves the prior disadvantages of conventional techniques, offering a method for effectively and efficiently creating electrical contacts. The following are some of the advantages offered by this invention:
- A method for depositing contacts with a high degree of flexibility, both in the width and height values of the contact and in the possibility of rapid changes to the pattern used, i.e. there is a high degree of flexibility with regard to the template or pattern to be created,
- Increased resolution of the height and width values of contacts,
- Increased process speed,
- Minimised thermal effects during sintering, limited to the area with contacts and not the cell/optoelectronic device as a whole,
- Minimised energy consumption in creating the electrical contacts.

In addition, the contacts created by means of this invention allow electricity to be both conducted and extracted. The process saves on contact material, as it only uses the exact amount required to create the same and does not require subsequent cleaning processes or additional thermal treatments.

### Description of the invention

The present invention refers to a method for creating electrical contacts in electronic and optoelectronic devices.

Defined below are some elements used in describing the stages of the method, to aid understanding of the same.

Final substrate: this is the surface on which the contact is to be deposited. Thus it is the surface of any electronic or optoelectronic device.

Donor substrate: a film transparent to the laser, used as a carrier for the contact material and from which its transfer to the final substrate will be made.

Predeposit: this is the deposit of contact material on the donor substrate.

Contact material: this is the material to be transferred to the final substrate to serve as a contact and is preferably a metal-based paste with good conductive properties either intrinsically or after undergoing a curing process.

The metallic paste should preferably contain a metal with a high degree of electrical conductivity such as copper, silver, etc. A paste of carbon nanoparticles, carbon nanotubes, graphene paste or graphene film may also be used as a contact material.

Metallic pastes are mixtures that in addition to the metal contain a series of components such as frits of mainly glass, rheology modifiers, solvents, sintering controllers and other additives. The percentage of metal in the paste can vary between 10 and 99%. Common values for the percentage of metal are between 40 and 90% and preferably between 75 and 85%.

The objective of the present invention is to describe a method for creating electrical contacts through the transfer of a metallic paste or contact material from a donor substrate to a final substrate and its subsequent sintering.

The method includes the following stages:
- Depositing the contact material or metallic paste on the final substrate by transferring said material from a donor substrate to the final substrate using laser induced forward transfer (LIFT). Preferably pulsed lasers are used to deposit the contact material.
- Sintering the contact material or metallic paste to ensure said contact material or metallic paste's cohesion and lower its resistance, such that is electrical resistivity and adherence to the final substrate allow it to be used for the injection or extraction of current. This sintering process is performed using a laser, preferably a continuous laser.

For depositing the metallic paste, the donor substrate is placed next to the final substrate, such that the metallic paste is located between them. Using selective radiation with a laser source, the metallic paste is transferred to the final substrate such that it forms the contacts on the same. The following variables must be taken into account during this stage:
- Thickness of the metallic paste predeposit on the donor substrate. This variable primarily influences the final thickness of the deposit on the final substrate. In the case of applications to photoelectric cells, the predeposit thicknesses used are 150 microns or less and preferably between 40 and 60 microns.
- Distance between the donor substrate and the final substrate. This variable primarily influences the transfer resolution. Its value must be in relation to the predeposit thickness. It can vary between tenths and thousands of microns, with values usually situated between 0.1 and 1000 microns and preferably between 50 and 100 microns.
- Characteristics of the laser beam used (average power, sweep speed, beam diameter, pulse repetition frequency, laser wavelength, laser fluence, peak power). The lasers used and their characteristics depend on the characteristics of the metallic pastes used to form the contact, the desired size of the final deposit, the process speed required, etc.

Sintering the metallic paste is essential in order to decrease the contact's resistance, as well as to achieve good adherence of the metallic paste to the final substrate, as the sintering process enables the creation of strong bonds between particles in the contact material. The sintering process is performed using a laser source, preferably a continuous laser. The laser variables (power, wavelength, beam diameter) and irradiation conditions (sweep speed, spot size) are dependent on the thickness of the deposit, the type of material and the geometry of the deposit.

Depending on whether the device does or does not include a dielectric layer between the surface to contact and the material deposit described, it may be necessary to create a window in said dielectric surface in order for the contact to have the necessary electrical properties. Said opening in the dielectric layer can also be made using a pulsed laser, preferably in the picoseconds range. In those technologies where the metallic paste is transferred to a material with acceptable conductivity conditions, such as transparent conductive oxides, it is not necessary to make a window in the dielectric surface.

The deposit of conductive metallic paste is irradiated using a laser beam. To do so, the laser beam is made to sweep the deposit such that the irradiation time allows for the entire block of metallic paste to be sintered.

In this process heating is produced only on the metallic paste and does not significantly affect the rest of the device, nor are further thermal processes required. For this reason, it can be used on both plastic and polymer devices and on devices that cannot be subjected to high processing temperatures, such as devices with hereto-junctions in their structure. The continuous laser enables deep and complete sintering of the metallic layer.

Unlike sintering in a furnace, with laser sintering the thermal effects are minimal as the laser beam is directed at the contact with the transferred material, while the rest of the device remains cold. Thus, in the method of the present invention, selective sintering is performed, with lower energy consumption and a lower global thermal load on the device. The complexity of the sintering process is in the choice of the type of laser source. Different sintering depths can be obtained depending on the laser source and the metallic paste used. Continuous lasers give good penetration results, achieving electrical conductivity after sintering similar to that achieved with furnace sintering processes. The choice of the power of the source, beam diameter (usually close to the width of the transferred line) and sweep speed is of the utmost importance.

In a preferred embodiment of the sintering process, a continuous green laser with a power of approximately 5-20 watts and spot size of approximately 120 microns is used, with sweep speeds between 1 mm/s and 500 mm/s.

Pulsed laser sources make control of the sintering process's intrinsic thermodynamic properties more difficult, and it is therefore more convenient to use continuous laser sources for this stage of the method. The use of pulsed lasers is limited to very specific applications wherein the thickness of the deposited lines is extremely low, requiring the thermal loads on the material to be sintered to be minimised. Nevertheless, for the patterns generally used on electronic and optoelectronic devices, continuous lasers enable the deposit to be deeply and uniformly penetrated and sintered.

The combination of these two techniques (LIFT and laser sintering) leads to contacts with excellent conductive properties, good adherence, a high height to width ratio of the contact and complete and deep contact sintering without the need to undergo an additional contact regrowth stage. The least electrical resistance (greatest contact height or cross-section) with the smallest contact area (contact width) is sought in order to avoid shading. The greater the aspect ratio, or height-width ratio of the contact line, the more efficient it is.

The width of the electrical contacts created using the method of the present invention varies between 4 and 200 microns, preferably being between 50 and 100 microns. With regard to the height-width ratio of the line, values range from 0.0001 to 0.5.

For line widths of approximately 4 microns, used in contacts for multi-junction cells such as those used in high concentration photovoltaics, low wavelength lasers (355 nm for example) can be used for sintering.

In the method of the present invention, different metallic pastes can be used to create the contacts, without the need to undergo an intermediate drying and sintering process between depositing one metallic paste and the next. Thus, for example, either a high conductivity metallic paste or a metallic paste with good adherence can be used, or both pastes can be used to create a single deposit, depending on requirements. A single paste can also be used to form different types of contacts, for example, superimposing lines to achieve a greater aspect ratio.

In the case of a standard commercial solar cell, there are two differentiated areas of metallization on the front: one part is the electrical contacts (known as "fingers") that form the first metallization phase and the purpose of which is to extract current from the surface of the device and conduct it to the contacts in the second phase of metallization, known as "busbars". The fingers must be as thin as possible, with excellent contact with the substrate and a high height-width ratio of the contact line, so as to have high conductivity and a good electrical junction. The purpose of the busbars is to receive current from the fingers and transfer it to the ribbon soldered on the former. For the busbars, the most important thing is that adherence to the substrate is excellent, in order to avoid problems with reliability during the soldering process. Consequently, depending on the type of contact to be deposited, a metallic paste with good adherence or good conductivity may be used as contact material, or two different pastes can be used the create a single type of contact, or a single paste to create two types of contact.

The electronic devices may be LEDs (light-emitting diodes), OLEDs (organic light-emitting diodes) or III-V cells, which are solar cells made from elements in columns III to V of the periodic table and used in high-concentration photovoltaic solar panels. In the last case, the contacts may be formed i) on the front where the p-n junction is located (metallic mesh of fingers with current transferred out of the cell by busbars located on the sides), ii) on the rear, arranged identically but on the rear (both fingers and busbars), iii) the fingers located on the front, conductors/paths passing through the cell (also metallic) and connecting to the busbars located at the p-n junction on the rear.

### Description of the drawings

To supplement the description in this document and in order to aid comprehension of the invention, a set of illustrative, non-restrictive drawings are provided, representing the following:
Figure 1: Shows a diagram of the stage comprising the deposition of the metallic paste on the final substrate (Figure traceable to the state of the art).
Figure 2: Shows a graph of height vs horizontal distance (width) of the contact line deposited using the LIFT technique.
Figure 3: Shows two graphs of the resistance of the contact, deposited with the commercial silver pastes SOL 540 and SOL 550 made by Heraeus ® respectively, as a function of laser power with and without sintering.

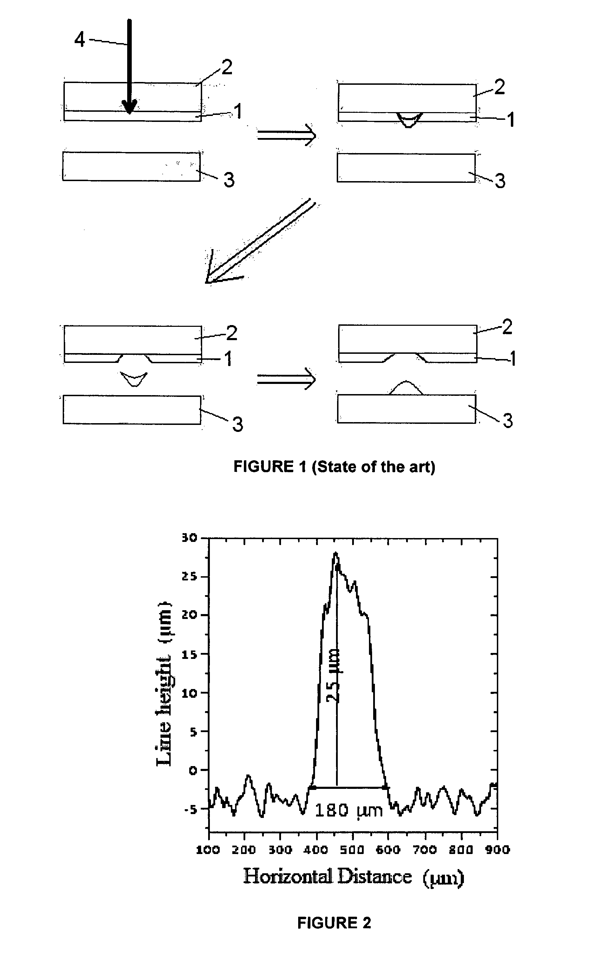

The numeric references appearing on figure 1 are as follows:
1.- Contact material
2.- Donor substrate
3.- Final or receiver substrate
4.- Laser

### Detailed description of the invention

Below is a description of the creation of metallic contacts using the following materials: Contact material (1): two different commercially available pastes, Heraeus ® models SOL 540 and SOL 550, are used.

### Characteristics:

| **Paste** | **SOL 540** | **SOL 550** |
|---|---|---|
| Viscosity | 40-60 kpcs | 30-50 kpcs |
| Resistivity | < 10 mΩ/□/25µm | < 10 mΩ/□/25µm |
| Adhesion | > 3 N | - |
| Solids (%) | 80 | 86.5 |
| Polymer type | thermostable | thermoplastic |
| Curing temp | 250-280°C | 200-230°C |
| Curing time | 3-8 min | 10-15 min |

Donor substrate (2): this is a glass plate transparent to the laser. The thickness of the silver paste on the donor substrate (predeposit thickness) is between 40 and 50 microns. Final or receiver substrate (3): this is a transparent conductive oxide (TCO) thin film. Laser (4) for the metallic paste transfer process: A Spectra Physics 532-2 532 nm laser with a 15 ns pulse, frequencies of 20 to 150KHz, beam width of 30 µm and maximum power of 2 W is used.

-For the Sol540 silver paste, the laser variables used for the metallic paste transfer process are the following: optimum power 3.7 W, window 2.2 to 4.0 W, sweep speed 3 mm/s and spot size 120 microns in diameter

For the Sol550 silver paste, the laser variables used are the following: Optimum power 3.4 W, window 2.0 to 3.8 W, sweep speed 3 mm/s and spot size 120 microns in diameter

As shown in figure 1, firstly the silver paste (1), initially situated on a glass plate or donor substrate (2) is deposited on the final substrate (3) by means of the pulsed laser (4) described above.

Figure 2 shows a diagram of the height and horizontal distance (width) of the contact line deposited by laser induced forward transfer (LIFT), which allows a high height to width ratio to be achieved. I.e., unlike with conventional techniques, it is possible to obtain very high or thick lines (approx. 25 microns) that are narrow or have a small horizontal distance, in the order of 100 microns.

Once the metallic paste (1) has been deposited on the final substrate (3), the deposited paste is sintered. For this too, a Spectra Physics laser source is used, the Millennia ® model. This is a continuous laser with a maximum power of 10W, wavelength of 532 nm, scan speed of 3 mm/s and spot diameter of 120 microns.

Sintering is performed at different powers for each of the two pastes, obtaining very acceptable results in a range sufficiently wide to consider the process robust. The quality of the results is dependent on the resistance. At lower resistances, current can more easily be extracted from/injected into the device.

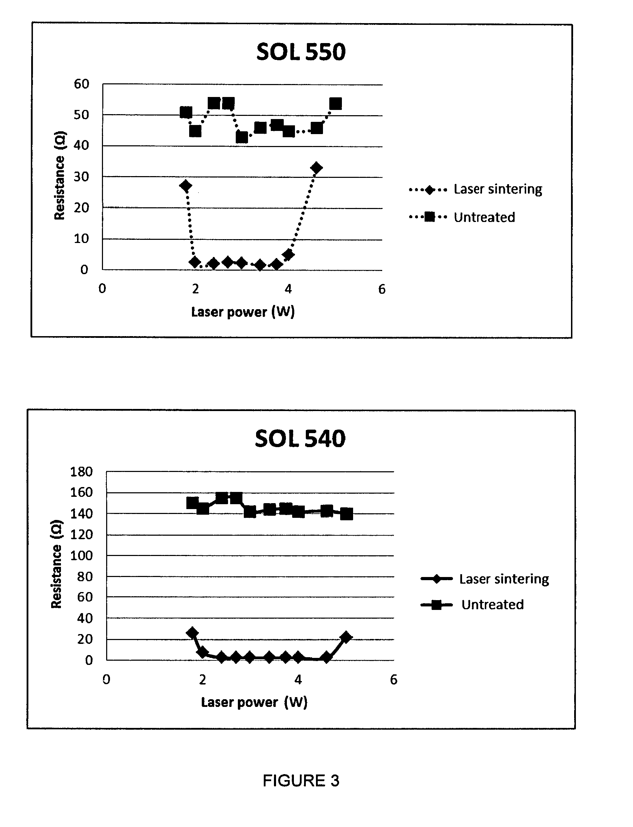

As can be seen in figure 3, the resistance of the sintered pastes is around 20 times less than without sintering.

The great advantage of laser heating is that it enables the metallic contact to be selectively heated, without affecting the rest of the optoelectronic device. Additionally, the use of a continuous laser allows partial and deep sintering of the contact and not merely the superficial sintering that occurs on occasion with conventional techniques (furnaces) limited to a temperature that will not affect the optoelectronic device in question.

Thus the combination of the laser induced forward transfer (LIFT) technique and laser sintering produces contacts with optimal electrical characteristics as shown in figure 3, without the optoelectronic substrate being affected during the process. Thus, for the SOL540 metallic paste, a resistance of 1.24Ω is achieved with a laser power of 3.4W during sintering. For the SOL550 metallic paste, a resistance of 1.5Ω is achieved with a laser power of 3.7W.

## Claims

1. A method for creating electrical contacts in electronic or optoelectronic devices, **characterised in that** it comprises the following stages:
- depositing the contact material (1) on a final substrate (3) through the laser-induced forward transfer (4) of said material from a donor substrate (2) containing a predeposit of the contact material (1) to the final substrate (3), which is the electronic or optoelectronic device,
- sintering the contact material using a laser source.

2. A method for creating electrical contacts according to claim 1, wherein the laser source used in the deposition stage is a pulsed laser source.

3. A method for creating electrical contacts according to claim 1, wherein the laser source used in the sintering stage is a continuous laser source.

4. A method for creating electrical contacts according to claim 3, wherein the continuous laser used for sintering is green, with a power of between 5 and 20 watts, spot size of 120 microns and sweep speeds of between 1 mm/s and 500 mm/s.

5. A method for creating electrical contacts according to claim 1, wherein the laser source used in the sintering stage is a pulsed laser source.

6. A method for creating electrical contacts according to claim 1, wherein the thickness of the contact material predeposit on the donor substrate is 150 microns or less.

7. A method for creating electrical contacts according to claim 6, wherein the thickness of the contact material predeposit on the donor substrate is between 40 and 60 microns.

8. A method for creating electrical contacts according to claim 1, wherein the distance between the donor substrate and the final substrate during the deposition process varies between 0.1 and 1000 microns.

9. A method for creating electrical contacts according to claim 8, wherein the distance between the donor substrate and the final substrate during the deposition process is between 50 and 100 microns.

10. A method for creating electrical contacts according to claim 1, wherein the contact material used is a conductive metallic paste.

11. A method for creating electrical contacts according to claim 1, wherein the contact material used is a paste of carbon nanoparticles, carbon nanotubes, graphene paste or graphene film.

12. A method for creating electrical contacts according to claim 10, wherein the metallic paste contains silver or copper.

13. A method for creating electrical contacts by means of the process described in claim 1, wherein the electrical contacts created have a height to width ratio of between 0.0001 and 0.5.

14. A method for creating electrical contacts by means of the process described in claim 1, wherein the electrical contacts created have a width that varies between 4 and 200 microns.

15. A method for creating electrical contacts according to claim 14, wherein the width of the electrical contacts is between 50 and 100 microns.

16. A method for creating electrical contacts according to claim 1, wherein the electronic devices are LEDs, OLEDs or solar cells made from elements in columns III to V of the periodic table.

17. A method for creating electrical contacts according to claim 16, wherein the contacts are created on the front or rear of the electronic device, this being a solar cell made from elements in columns III to V of the periodic table.

18. Electrical contacts created by means of the method described in any of the previous claims.
